**Europäisches Patentamt**

**European Patent Office**

**Office européen des brevets**

(19)

(11) **EP 1 439 637 A1**

(12) **DEMANDE DE BREVET EUROPEEN**

(43) Date de publication:
**21.07.2004 Bulletin 2004/30**

(21) Numéro de dépôt: **03368126.3**

(22) Date de dépôt: **23.12.2003**

(51) Int Cl.7: **H03M 5/00**, H03M 5/04,
H03M 7/40, H03M 5/14,
G11B 20/14, H03M 7/46,
G06F 7/00, G06F 7/02,
G06F 17/30, G06F 7/544,
H03H 17/02

(84) Etats contractants désignés:
**AT BE BG CH CY CZ DE DK EE ES FI FR GB GR
HU IE IT LI LU MC NL PT RO SE SI SK TR**
Etats d'extension désignés:
**AL LT LV MK**

(30) Priorité: **23.12.2002 FR 0216492**

(71) Demandeur: **STMicroelectronics S.A.
92120 Montrouge (FR)**

(72) Inventeur: **Lehongre, Denis
38530 Pontcharra (FR)**

(74) Mandataire: **Schuffenecker, Thierry
97, chemin de Cassiopée,
Domaine de l'étoile
06610 La Gaude (FR)**

(54) **Dispositif pour le traitement collectif de données**

(57) Dispositif de traitement de données numériques, et notamment d'extraction de maximum ou de minimum parmi des valeurs appartenant à un ensemble de $2^n$ codes dans lequel une relation d'ordre est établie et pour lequel chacune desdites données dispose d'un rang R compris entre 0 et $2^n-1$, le circuit étant caractérisé en ce qu'il comporte :

- un circuit de conversion pour chaque donnée numérique à traiter afin de générer une transformée qui est un nombre binaire composé de $2^n-1$ éléments binaires **T[x]** avec x = 1 à $2^n-1$ :

$$T[2^n-1]\ T[2^n-2]\ ...T[x]\ ...\ T[2]\ T[1]$$

Dans lequel on a T(x) = 0 lorsque x est strictement supérieur à R et T(x)=1 lorsque x est inférieur ou égal à R,

- des circuits recevant le résultat desdites conversion et effectuant un traitement numérique sur ledit résultat.

L'invention permet de réaliser un circuit d'extraction de maximum ou de minimum à haute vitesse.

Fig. 4

EP 1 439 637 A1

EP 1 439 637 A1

## Description

### Domaine technique de l'invention

La présente invention concerne le traitement numérique d'informations et plus particulièrement un dispositif pour le traitement collectif de grands nombres de valeurs et données.

### Etat de la technique

Avec le développement des technologies de l'information le nombre de données que les systèmes sont appelés à traiter s'accroît d'une manière constante. Ce traitement est généralement effectué au sein circuit électronique de type ALU *(Arithmetic Logic Unit)* ou pré-diffusé ou pré-caractérisé ou encore *«full custom»* suivant la terminologie anglo-saxonne.

Lorsque l'on doit traiter collectivement un grand nombre de données, comme par exemple pour effectuer l'extraction d'un maximum, le traitement peut devenir particulièrement lourd et requérir un grand nombre d'étapes.

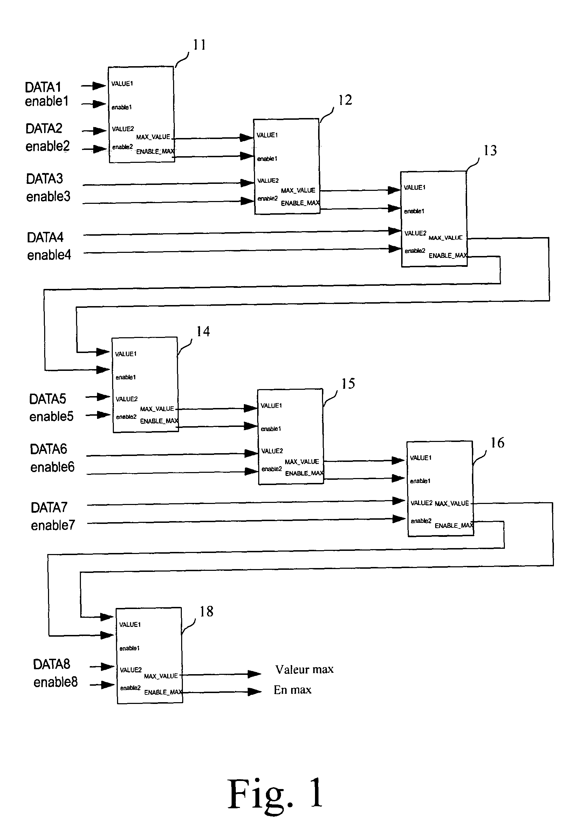

La figure 1 montre une manière classique permettant d'extraire le maximum d'un ensemble de Nd valeurs - par exemple huit valeurs DATA1 à DATA8 (associées à leurs signaux Enable1 à Enable8). A cet effet, un ensemble de huit blocs élémentaires 11-18, permettent la comparaison de deux valeurs, deux à deux. Chacun des blocs fonctionnels fournit alors la valeur maximale ainsi qu'un signal de sélection Enable_Max le cas échéant. Dans un tel traitement en cascade, que l'on peut qualifier de type *« compare and forward »* suivant l'expression anglo-saxonne, on pénalise considérablement le temps de traitement puisqu'il faut effectuer les opérations en série, les unes après les autres. Dans une telle structure, on obtient le résultat, d'une manière générale, au bout de Nd -1 opérations si Nd représente le nombre de données à traiter.

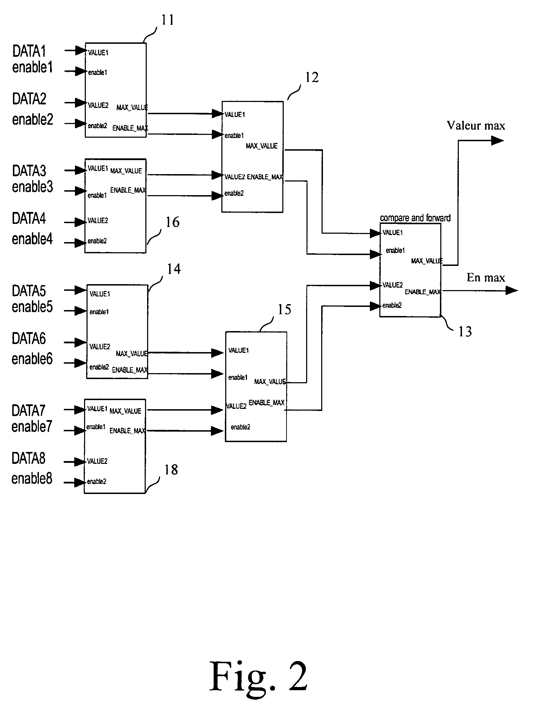

Suivant une seconde méthode connue, on arrive à réduire le temps de traitement de l'opération considérée en réorganisant les différents blocs fonctionnels de manière arborescente, telle qu'illustrée en figure 2. On constate à présent que l'on peut réaliser l'opération en trois étapes seulement (pour un ensemble de huit valeurs) du fait que les blocs 11, 14, 16 et 18 peuvent démarrer leur traitement simultanément.

Bien que la seconde méthode améliore le temps de traitement, celui-ci reste encore élevé (variant avec le logarithme de Nd) et il est bien des applications pour lesquelles il serait souhaitable de réduire encore le temps de traitement collectif des données.

Le problème est d'ailleurs général. On peut considérer bien d'autres types de traitement collectif de données, par exemple l'extraction d'un minimum, la comparaison avec une valeur de consigne etc...

Lorsque les contraintes de temps deviennent critiques, par exemple pour les grands calculateurs dans lesquels il s'agit d'effectuer des tris complexes ou encore pour le traitement en temps réel, il faut pouvoir traiter les données encore plus rapidement que suivant les méthodes connues.

Pour ces raisons, on ne peut en général se satisfaire des possibilités offertes par les unités logiques programmables. La réalisation d'un circuit électronique spécifique reste alors la seule possibilité permettant de réduire le temps de traitement d'un grand nombre de données. Il reste que même avec les outils de synthèse connus, cela ne permet de générer que des structures apportant des performances limitées, car on se ramène en gros à une approche telle que celle décrite dans les figures 1 et 2.

On souhaite pourtant pouvoir maintenir un traitement totalement numérique tout en réduisant le temps de calcul lorsqu'il s'agit de traiter un grand nombre de données.

### Exposé de l'invention

La présente invention a pour but de proposer une nouvelle architecture de circuit électronique spécialisé permettant de traiter un grand nombre de données, et d'effectuer sur ces données une opération telle que l'extraction d'un maximum par exemple.

L'invention réalise ces buts au moyen d'un dispositif de traitement d'un ensemble de données numériques appartenant à un ensemble ordonné dans lequel une relation d'ordre est établie et pour lequel chacune des données dispose d'un rang R compris entre 0 et $2^n-1$, Le circuit comporte :

- un circuit de conversion pour chaque donnée numérique à traiter afin de générer une transformée qui est un nombre binaire composé de $2^n-1$ éléments binaires **T[x]** avec x = 1 à $2^n-1$ :

    **T[$2^n$-1] T[$2^n$-2] ...T[x] ... T[2] T[1]**

Dans lequel on a T(x) = 0 lorsque x est strictement supérieur à R et T(x)=1 lorsque x est inférieur ou égal à R, Alternativement, on génère une transformée qui est un nombre binaire composé de $2^n$ éléments binaires **T[x]** avec x = 0

à $2^n-1$ :

$$T[2^n-1] \; T[2^n-2] \; ... \; T[x] \; ... \; T[1] \; T[0]$$

Le dispositif comporte en outre des circuits recevant le résultat desdites conversions et effectuant un traitement numérique sur ledit résultat.

Les transformées qui sont générées présentent la particularité de pouvoir être très simplement manipulées quel que soit le nombre de données à traiter.

En effet, lorsque le traitement numérique, sur l' ensemble des données à traiter, ayant subit la transformée, est un OU booléen effectué bit à bit sur les bits de même indice, suivi d'une conversion inverse de ladite transformée, on obtient directement et très rapidement le maximum d'un ensemble de valeurs numériques.

Inversement, lorsque le traitement numérique, sur l'ensemble des données a traiter, ayant subit la transformée, est un ET booléen effectué bit à bit sur les bits de même indice, suivi d'une conversion inverse de la dite transformée, on obtient alors directement, en un temps extrêmement court, le minimum d'un ensemble de valeurs ou de données.

On arrive ainsi à rendre parallèle un grand nombre d'opérations et il ne faut plus que trois opérations élémentaires pour extraire le maximum d'un grand nombre de valeurs. En outre, on peut traiter ainsi toute sorte de format : signées ou non signées, avec mantisse et exposants, Gray , Johnson etc...

Alternativement, si l'on adopte la convention suivant laquelle:

$T(x) = 1$ lorsque x est strictement supérieur à R et $T(x)=0$ lorsque x est inférieur ou égale à R, avec R étant le rang dans le dit ensemble ordonné, on obtient alors l'extraction d'un maximum, sur l'ensemble des données ayant subit la transformée, au moyen d'un ET booléen, effectué bit à bit sur les bits de même indice, suivi d'une conversion inverse de ladite transformée. En combinant un OU booléen effectué bit à bit sur les bits de même indice, sur l'ensemble des données ayant subit la transformée, suivi d'une conversion inverse de ladite transformée, on obtient, en un temps très court, l'extraction du minimum d'un ensemble de valeurs numériques.

On arrive ainsi à rendre parallèle un grand nombre d'opérations et il ne faut plus que trois opérations élémentaires pour extraire le maximum d'un grand nombre de valeurs. En outre, on peut traiter ainsi des valeurs ayant toute sorte de format signé ou non signé, avec mantisse et exposants etc...

L'invention permet de réaliser des circuits d'extraction de maximum et de minimum opérant à une très grande vitesse.

## Description des dessins

D'autres caractéristiques, but et avantages de l'invention apparaîtront à la lecture de la description et des dessins ci-après, donnés uniquement à titre d'exemples non limitatifs. Sur les dessins annexés :

La figure 1 illustre une première manière connue permettant d'extraire une valeur maximale au sein d'un ensemble de huit données.

La figure 2 représente une seconde manière connue permettant d'extraire une valeur maximale au sein d'un ensemble de huit données.

La figure 3 illustre un mode de réalisation préféré d'un circuit d'extraction du maximum d'un ensemble de huit données.

La figure 4 détaille le circuit 209 effectuant la combinaison OU appliquée à trois valeurs codées sur 3 bits.

La figure 5 illustre un mode de réalisation préféré d'un circuit d'extraction du minimum d'un ensemble de huit données.

La figure 6 détaille le circuit 309 effectuant la combinaison ET appliquée à trois valeurs codées sur 3 bits.

La figure 7 illustre une représentation sous forme de blocs fonctionnels du transcodeur conditionnel exclusif pour des codes de trois bits.

La figure 8 illustre la manière d'agencer les transcodeurs conditionnels exclusifs 501 à 507 pour réaliser la fonction de transformée en T inverse pour des données codées, avant conversion en T, sur trois bits.

La figure 9 montre une opération de comparaison d'égalité entre la transformée en T d'une valeur codée sur 7 bits à une valeur de référence.

La figure 10 illustre une opération de comparaison strictement supérieure d'une transformée en T d'une valeur codée sur 7 bits à une valeur de référence *(trigger2)*

La figure 11 est une adaptation de la figure 10 pour déterminer si une valeur d'une transformée en T est supérieure ou égale à une autre.

La figure 12 illustre une manière de réaliser la fonction de transformée en T pour des données codées sur trois bits.

**Description d'un mode de réalisation préféré**

Pour réduire le temps de traitement collectif des données, on fait intervenir une fonction de conversion ci-après désignée transformée en T, laquelle permet de générer un codage intermédiaire de chacune des valeurs DATAx devant être manipulées.

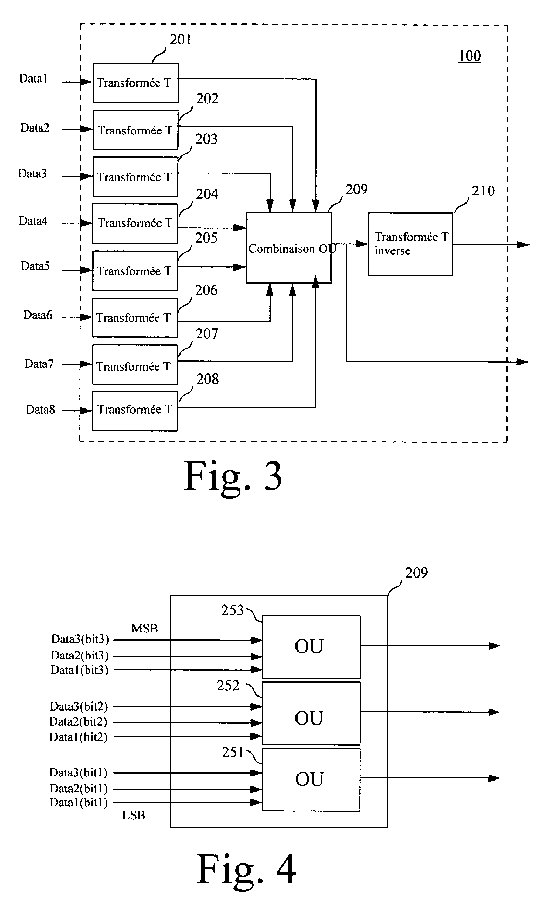

Cette fonction de conversion sera utilisée sous sa première forme, décrite ci après, dans l'ensemble des exemples illustrés par les figures 3 à 12.

Les valeurs B sont codées sur n bits et sont supposées appartenir à un ensemble ordonné, comportant $2^n$ éléments, dans lequel une relation d'ordre est établie et pour lequel chacune des données dispose d'un rang compris entre 0 et $2^n$-1. La relation de rang entre les données à traiter et la transformée en T est définie de la manière suivante :

Un vecteur **B[n-1] B[n-2] .... B[2] B[1] B[0]** sera transformé en un nombre binaire composé de $2^n$-1 bits :

**T[$2^n$-1] T[$2^n$-2].... T[x] ... T[2] T[1] avec x=1 à $2^n$-1**

Dans lequel on a T(x) = 0 lorsque x est strictement supérieur à R et T(x)= 1 lorsque x est inférieur ou égal à R, avec R étant le rang dans le dit ensemble ordonné , à savoir, si l'on prend l'exemple de valeurs décimales :

$$R = B[n-1] \times 2^{(n-1)} + B[n-2] \times 2^{(n-2)} + ... + B[2] \times 2^2 + B[1] \times 2^1 + B[0] \times 2^0$$

On observe que cette définition du rang R confère à la présente transformée en T les particularités suivantes : en premier lieu, il y a une relation bijective entre le code binaire et sa transformée en T. En second lieu, un élément binaire quelconque T(x) de la transformée en T est à « 1 » uniquement lorsque les bits de poids inférieur sont également à 1.

Ainsi, pour des données codées sur trois bits, on aura les correspondances suivantes :

| Code binaire initial | transformée en T | rang |
|---|---|---|
| 000 | 0000000 | 0 |
| 001 | 0000001 | 1 |
| 010 | 0000011 | 2 |
| 011 | 0000111 | 3 |
| 100 | 0001111 | 4 |
| 101 | 0011111 | 5 |
| 110 | 0111111 | 6 |
| 111 | 1111111 | 7 |

La figure 3 représente un circuit de traitement collectif de données numérique conformément à l'invention, lequel permet, à des fins d'illustration, d'extraire la valeur maximale calculée entre un ensemble de 8 valeurs quelconques DATA1-DATA8. Il est clair que le circuit de la figure 3 n'est qu'un exemple parmi bien d'autres et que l'homme du métier pourra sans difficulté adapter l'invention à la réalisation de toute autre opération manipulant un ensemble de valeurs quelconques, et notamment l'extraction d'un minimum, ou toute autre opération quelconque devant traiter un grand nombre de valeurs etc...

On notera également que le nombre de valeurs peut être quelconque et n'est pas limité à huit. En outre, les données peuvent être exprimées sous n'importe quel format, signée ou non, ou autre, étant entendu qu'elle devront présenter la particularité de faire parti d'un ensemble sur lequel est défini une relation d'ordre.

On pourra envisager un deuxième type de transformée en T, basée sur la relation de rang définie précédemment, dont la valeur décimale « 0 » est transformée en une séquence de « 0 » et le bit LSB égal à 1. A titre d'illustration on montrera, ci-après, la correspondance pour cette deuxième définition de la transformée en T appliquée à des valeurs codées sur 4 bits :

| Code binaire initial | Transformée en T | rang |
|---|---|---|
| 0000 | 0000000000000001 | 0 |
| 0001 | 0000000000000011 | 1 |
| 0010 | 0000000000000111 | 2 |
| 0011 | 0000000000001111 | 3 |
| 0100 | 0000000000011111 | 4 |
| 0101 | 0000000000111111 | 5 |
| 0110 | 0000000001111111 | 6 |
| 0111 | 0000000011111111 | 7 |
| 1000 | 0000000111111111 | 8 |
| 1001 | 0000001111111111 | 9 |
| 1010 | 0000011111111111 | 10 |
| 1011 | 0000111111111111 | 11 |
| 1100 | 0001111111111111 | 12 |
| 1101 | 0011111111111111 | 13 |
| 1110 | 0111111111111111 | 14 |
| 1111 | 1111111111111111 | 15 |

Alternativement, si l'on adopte la convention suivant laquelle:

T(x) = 1 lorsque x est strictement supérieur à R et T(x)=0 lorsque x est inférieur ou égal à R,

avec R étant le rang dans le dit ensemble ordonné, on obtient alors l'extraction d'un maximum au moyen d'un ET booléen, effectué bit à bit sur les bits de même indice, suivi d'une conversion inverse de ladite transformée. En combinant un OU booléen , effectué bit à bit sur les bits de même indice, suivi d'une conversion inverse de ladite transformée, on obtient, en un temps très court, l'extraction du minimum d'un ensemble de valeurs numériques.

Comme on va le constater ci-après, la transformée en T présente l'aptitude à de nombreuses combinaisons et manipulations de données.

Si l'on s'en tient à la première définition de la transformée en T - celle suivant laquelle le décimal '0' correspond à la transformée « 000000...00 >> , on constate que l'on produit directement le rang de la valeur convertie à partir de l'addition des différents éléments binaires contenus dans cette dernière.

$$R = T[2^n-1] + T[2^n-2] + T[2^n-3] + ... + T[2] + T[1]$$

En outre, cette transformation en T peut être utilisée très avantageusement pour produire des circuits permettant des traitement collectifs de données ultra-rapides. Il en résulte alors une nouvelle classe de circuits électroniques conçus soit manuellement soit à l'aide d'un outil de compilation et de synthèse logique, qui apporte un traitement particulièrement rapide des ensembles de données.

En se référant à nouveau à la figure 3 on constate que chacune des huit valeurs DATA1 à DATA8 est transmise à l'entrée d'un circuit convertisseur, respectivement 201 à 208, lequel fournit en sortie la transformée en T correspondant à la valeur.

Les huit valeurs sont alors transmises à un circuit convertisseur 209 qui effectue un OU logique - bit à bit, sur les bits de même indice - entre les différentes valeurs fournies par les blocs 201 à 208.

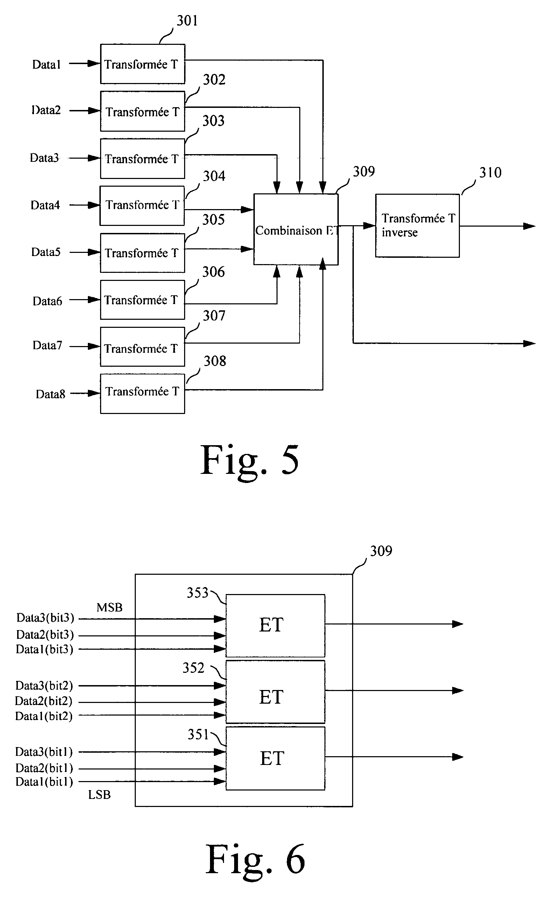

La figure 4 illustre un tel circuit convertisseur dans le cadre d'une application limitée à trois valeurs codées sur trois bits. Mais clairement, l'homme du métier pourra adapter l'invention au traitement d'un nombre quelconque de valeurs codées sur un nombre quelconque de bits. Le circuit 209 fournit alors en sortie une valeur qui est transformée par un circuit convertisseur 210 réalisant la conversion en T inverse.

On constate, qu'avec le schéma de la figure 3, toutes les conversions en T peuvent être effectuées en même temps et que par conséquent le traitement des huit valeurs peut être obtenu en seulement trois étapes. Il est à noter que, contrairement aux techniques classiques, telles que celle rappelée en référence à la figure 2, ce nombre d'étape devient indépendant du nombre de valeurs à traiter. Pour traiter 128 valeurs, par exemple, il suffit de prévoir un ensemble de 128 circuits de transformation en T.

On obtient ainsi, d'une manière extrêmement rapide, l'extraction du maximum d'un ensemble de données. La rapport du gain en vitesse obtenu par l'invention est d'autant plus élevé que le nombre de données à traiter sera important.

De préférence, les circuits de conversions 201-208, 209 et 210 seront intégrés dans un même circuit semi-conducteur. Le prix à payer pour permettre ce traitement ultra-rapide réside dans un accroissement de surface et ce à la mesure de l'accroissement du nombre de bits des valeurs à traiter. Ainsi pour traiter des valeurs de 8 bits, il faut envisager des transformées en T générant des mots de $2^8$ ou $2^8$-1 bits, à savoir 256 ou 255 bits.

Ainsi la transformée T définie précédemment tend à générer des codes ayant un grand nombre de bits et que, pour traiter ces nombres, il faut des unités logiques et arithmétiques (ULA) pouvant traiter suffisamment de valeurs binaires à la fois. Ci-dessous se trouve la correspondance entre le nombre de bits des données à traiter, et le nombre de bits des valeurs générées par la transformée en T :

| Nombre de bits : | Nombre de bits générées par la transformée en T : |
| --- | --- |
| 4 | 15 (ou16) |
| 5 | 31 (ou 32) |
| 6 | 63 (ou 64) |
| 7 | 127 (ou 128) |
| 8 | 255( ou 256) |
| 9 | 511 (ou 512) |
| 10 | 1023 (ou 1024) |
| ... | ... |
| n | $2^n$-1 (ou $2^n$) |

Clairement, un compromis entre la taille du circuit réalisé et ses performances en vitesse pourra être trouvé. Dans un monde de réalisation préféré, les données à traiter sont découpées par paquet de Nb bits afin de pouvoir générer, au moyen de transformées en T intermédiaires, des valeurs intermédiaires sur $2^{Nb}$-1 bits par exemple. Une fois le groupe contenant les bits de poids les plus grands traitées, on peut alors traiter le groupe de Nb bits ayant les poids les plus grands suivant non encore traiter et arriver, de proche en proche, à l'extraction du maximum en un nombre limité d'opérations, plus rapidement encore qu'avec les techniques classiques.

En pratique, on pourra se limiter au traitement de valeurs de quatre bits par exemple, ce qui conduira à la génération de transformée en T présentant 16 bits, lesquels seront aisément manipulables . Si l'on souhaite traiter des valeurs de plus de quatre bits, on procèdera alors à un découpage de chacune des valeurs à traiter en mots de quatre bits chacun et l'on opérera la conversion en T sur chacun des mots de quatre bits. De ce fait, on réinjecte un traitement série qui, s'il permet de réduire le nombre de bits des transformées en T et donc la surface de circuit semi-conducteur. Cela se traduit par une augmentation du temps de traitement qui reste cependant plus rapide que les solutions connues.

La figure 4 illustre un circuit convertisseur 209 permettant d'effectuer un OU logique, bit à bit , sur les bits de même indice, de trois données codées sur trois bits. Le circuit 209 fournit en sortie un vecteur codé sur trois bits OR [3] OR[2] OR[1 ]. Chacune des trois données est codée sur trois bits : DATA3[3] DATA3[2] DATA3[1] (resp. DATA2[3] DATA2[2] DATA2[1] ; DATA1[3] DATA1[2] DATA1[1]). Cette opération est réalisée à l'aide de trois OU logiques 251, 252 et 253 ayant chacun trois entrées. Le OU logique 251 (resp. 252 ; 253) dispose d'une première entrée connectée à DATA1[1] (resp. DATA1(2); DATA1(3)), une deuxième entrée connectée à DATA2[1] (resp. DATA2(2) ; DATA2(3)), une troisième entrée connectée à DATA3[1] (resp. DATA3(2) ; DATA3(3)) ainsi qu'une sortie connectée à OR[1] (resp. OR[2] OR[3]). Clairement, l'homme du métier pourra adapter l'invention au traitement d'un nombre quelconque de valeurs codées sur un nombre quelconque de bits.

La figure 5 illustre un mode de réalisation d'un extracteur de la valeur minimale d'un ensemble de données. Chacune des huit valeurs DATA1 à DATA8 est transmise à l'entrée d'un circuit convertisseur, respectivement 301 à 308, lequel fournit en sortie la transformée en T correspondant à la valeur.

Les huit valeurs sont alors transmises à un circuit convertisseur 309 qui effectue un ET logique - bit à bit sur les bits de même indice - entre les différentes valeurs fournies par les blocs 301 à 308.
Le circuit 309 fournit alors en sortie une valeur qui est transformée par un circuit convertisseur 310 réalisant la conversion en T inverse.

A nouveau, on s'aperçoit que l'on peut procéder à l'extraction du minimum d'un ensemble quelconque de données en un temps particulièrement court, ce qui ouvre la possibilité à toutes sortes d'applications, comme le traitement en temps réel même dans un contexte particulièrement critique.

La figure 6 illustre un circuit convertisseur 309 pour une application limitée à trois valeurs de trois bits. Ledit convertisseur 309 effectue un ET logique, bit à bit, sur les bits de même indices, de trois données codées sur trois bits et fournie en sortie un vecteur codé sur trois bits ET[3] ET[2] ET[1]. Chacune des trois données est codée sur trois bits : respectivement DATA3[3] DATA3[2] DATA3[1], DATA2[3] DATA2[2] DATA2[1] et DATA1[3] DATA1[2] DATA1[1]. Cette opération est réalisée à l'aide de trois ET logiques 351, 352 et 353 ayant chacun trois entrées. Le ET logique 351 (resp. 352, 353) dispose d'une première entrée connectée à DATA1[1] (resp. DATA1(2) ; DATA1(3) ) , une, deuxième entrée connectée à DATA2[1] (resp. DATA2(2) ; DATA2(3) ) , une troisième entrée connectée à DATA3[1] (resp. DATA3(2) ; DATA3(3) ) ainsi qu'une sortie connectée à ET[1] (resp. ET[2] ET[3].

Pour réaliser le convertisseur 210 ou 310 on pourra employer une structure réalisant la transformée en T inverse en deux étapes :

La première étape se présente sous la forme d'un transcodage conditionnel exclusif, basé sur un traitement deux par deux des éléments binaires de l'élément à transcoder. La sortie de cette première étape est une matrice cond_transcode composée de k vecteurs, avec chaque vecteur comportant n éléments binaires.

La deuxième étape consiste à ramener tous les vecteurs de la matrice cond_transcode au moyen d'un OU effectué bit à bit, sur les bits de même indice, en un seul vecteur qui est la valeur obtenue après transformation en T inverse.

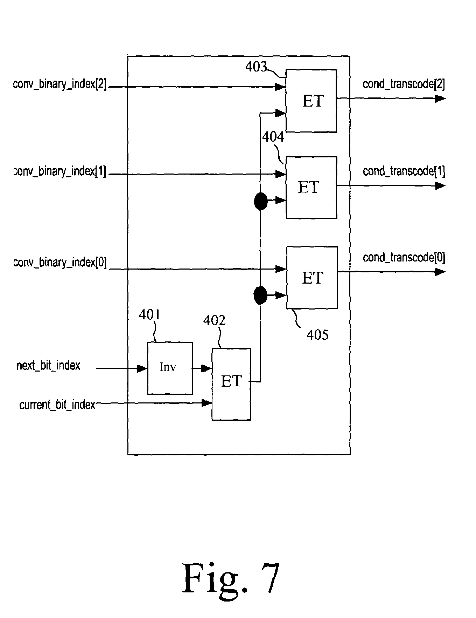

La figure 7 illustre une représentation sous forme de blocs fonctionnels du transcodeur conditionnel exclusif pour des codes de trois bits. La comparaison des deux éléments binaires voisins - à savoir *next_bit_index* et *current_bit_index* - est réalisée au moyen d'une porte ET 402 et d'un inverseur 401. La valeur de *next_bit_index* est transmise à l'inverseur 401, dont la sortie est connectée à une première entrée de la porte ET 402 dont une seconde entrée reçoit la valeur de *current_bit_index.* La sortie de la porte ET 402 est transmise à une première entrée d'un ensemble de trois portes ET 403, 404, 405, dont chacune présente une deuxième entrée recevant respectivement un vecteur codé sur 3 bits (i.e. *resp. conv_bin_index[0] à conv_bin_index[2]).* En sortie, le transcodeur conditionnel exclusif fournit trois éléments binaires, à savoir *code_transcode[0]* à *code_transcode[2]* respectivement.

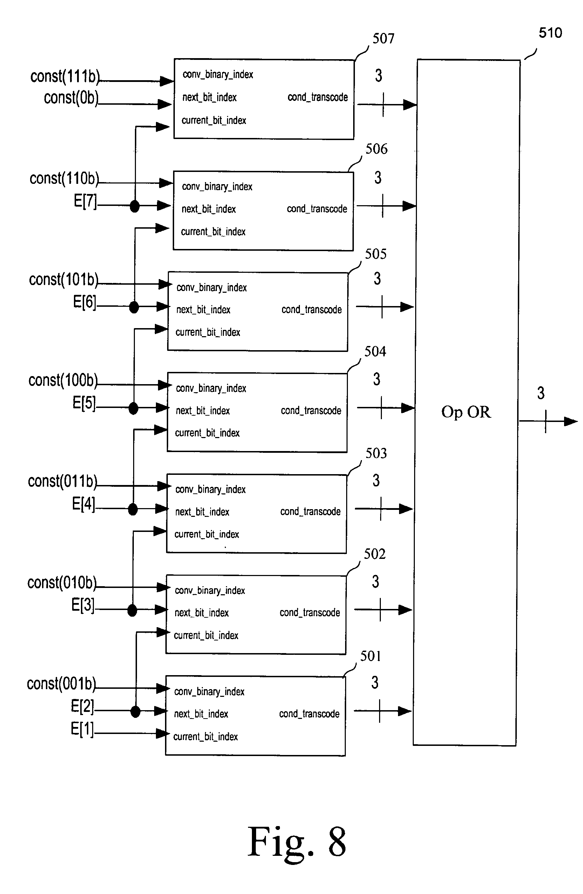

La figure 8 illustre la manière d'agencer les transcodeurs conditionnels exclusifs 501 à 507 pour réaliser la fonction de transformée en T inverse d'une valeur en T codée sur 7 bits, respectivement E[1] à E[7]. Sept constantes représentées par des valeurs binaires codées sur 3 bits et dont l'indice le plus grand se trouve à gauche, à savoir const(001b) const(010b) const(011b) const(100b) const(101b) const(110b) const(111b) respectivement, est dirigé vers les vecteurs d'entrée *conv_bin_index* d'un transcodeur 501 à 507 respectivement. L'entrée *next_bit_ index* du transcodeur (resp 501 à 506) reçoit l'élément E[2] à E[7] respectivement . L'élément E(1) est, quant à lui, transmis à l'entrée *current_bit_index* du transcodeur 501. Une constante binaire codée sur un bit, égale au '0' logique, dénommée const (0b) est, quant à elle, transmise à l'entrée *next_bit_index* du transcodeur 507. Chaque entrée *next_bit_index* d'un transcodeur 501 à 506 respectivement est connecté à l'entrée *current_bit_index* du transcodeur 502 à 507 respectivement. Les sorties des transcodeurs 501-508 sont ensuite appliquées à un opérateur booléen OU 510, qui réalise ladite fonction OU bit à bit sur les bits de même indice, et lequel fournit en sortie, la valeur de la transformée en T inverse sur trois bits.

D'une manière générale, on pourra envisager toute manière de réaliser les circuits convertisseurs 301-308 pour la transformée en T, et le circuit 310 pour réaliser la fonction inverse.

Une fois les valeurs à traiter converties suivant la transformée en T, il devient très facile d'effectuer toutes sortes d'opérations.

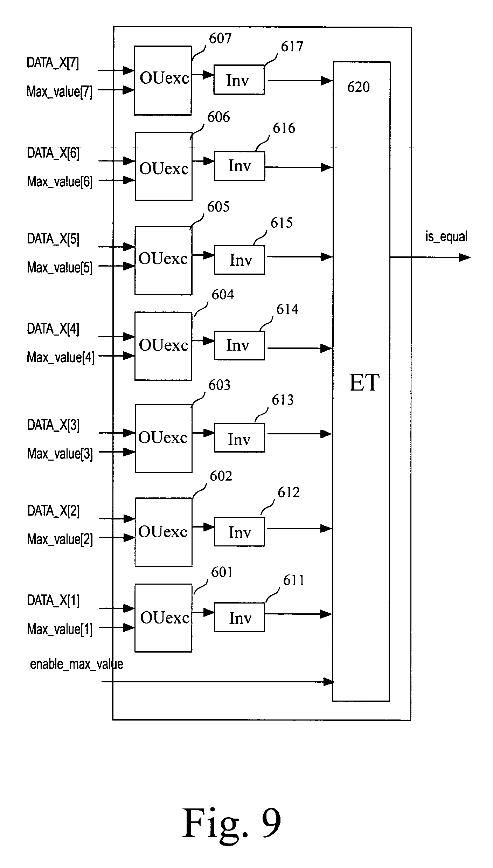

Les figures 9 à 11 illustrent des exemples d'opérations pouvant être réalisées sur les transformées en T. On constatera, à nouveau, que le traitement s'effectue en un temps court sur une valeur transformée en T.

La figure 9 montre une opération permettant de faire une comparaison d'égalité entre la transformée en T d'une valeur à une valeur de référence, par exemple la valeur maximale calculée précédemment. Comme on le voit, chaque élément binaire de la transformée en T, codée sur sept bits, (respectivement DATAX[1] à DATAX[7]) à traiter est transmis à une entrée d'une porte OU exclusif (respectivement 601 à 607) dont une seconde entrée reçoit une valeur de référence codée sur sept bits (respectivement Max_value[1] à Max_value[7]) . En sortie , chaque porte OU exclusif est connectée à un inverseur - respectivement 611 à 617 et dont la sortie est ensuite transmise vers une entrée d'une porte ET 620 dont une huitième entrée reçoit un signal d'enable dénommé *enable_max_value.* En sortie, la porte ET 620 fournit un signal de sortie *is_equal* qui est le résultat de la comparaison d'égalité entre la transformée en T de la valeur à comparer (respectivement DATAX[1] à DATAX[7]) et une valeur de référence (respectivement Max_value [1] à Max_value[7]).

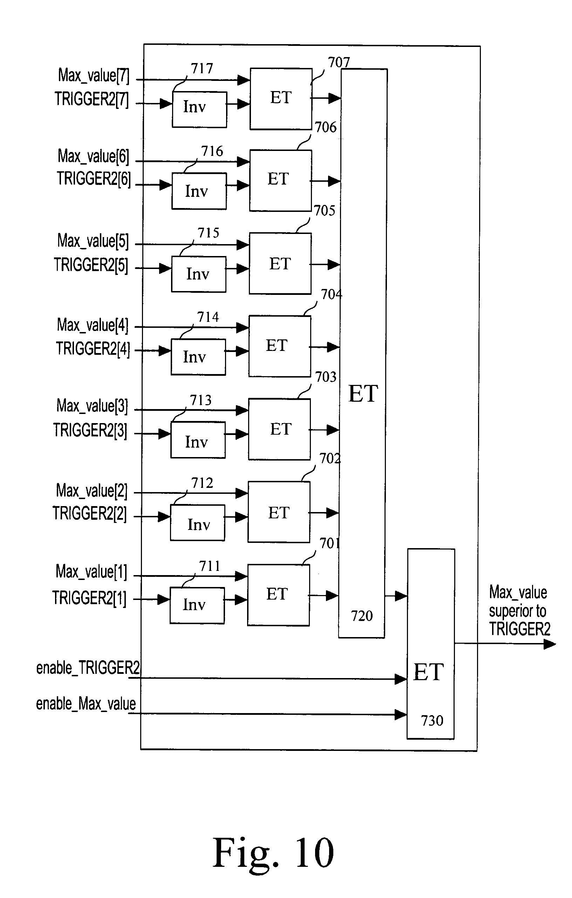

La figure 10 illustre une opération de comparaison de supériorité stricte d'une transformée en T codée sur sept bits - par exemple la valeur maximale extraite auparavant - avec une valeur de référence *(trigger2).* Chaque élément binaire de la transformée en T à traiter - à savoir *Max_value[1]* à *Max_value[7]* - est transmis à une première entrée d'une porte ET (resp. 701 à 707) ayant une seconde entrée connectée à la sortie d'un inverseur (resp. 711 à 717), lequel inverseur présente une entrée recevant une valeur de référence (resp. *trigger2[1]* à *trigger[7]*)). Les portes ET 701 à 707 présentent chacune une sortie qui est connectée à une entrée d'une porte ET 720 laquelle dispose d'une sortie connectée à une première entrée d'une porte ET 730, dont deux autres entrées reçoivent les signaux *ENABLE* des deux valeurs comparées (resp. *enable_max_value* et *enable_trigger2*). En sortie, la porte ET 730 fournit un signal de sortie *Max_value_superior to Trigger2* qui est le résultat de la comparaison de supériorité stricte entre les deux entrées.

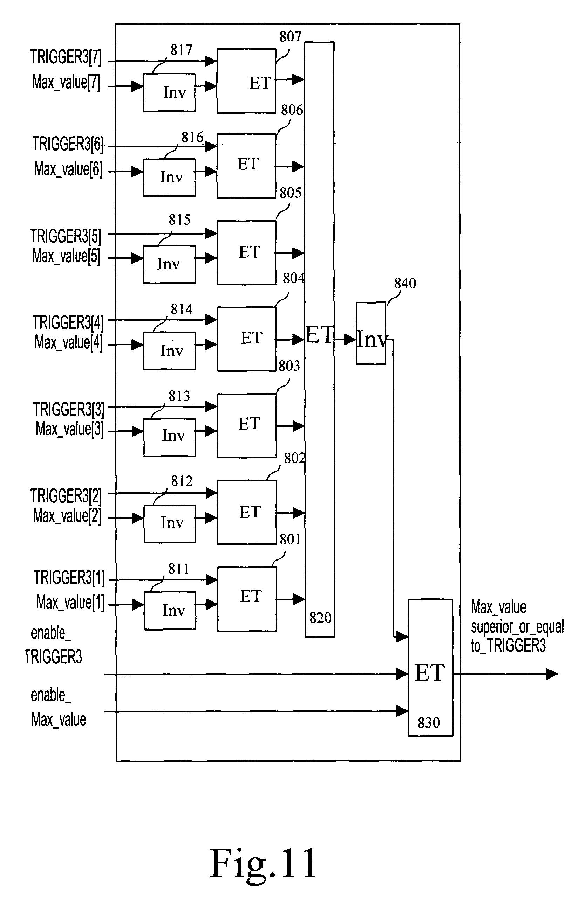

La figure 11 est une adaptation de la figure 10 pour déterminer si une valeur est supérieure ou égale à une autre. Comme précédemment, chaque élément binaire de la transformée en T à traiter (resp *Max_value[1] à Max_value [7]*) est transmis à une première entrée d'une porte ET (resp. 801 à 807) dont une seconde entrée est connectée à la sortie d'un inverseur, resp. 811 à 817. Ces derniers présentent chacun une entrée recevant une valeur de référence (resp. *trigger3[1]* à *trigger3[7]*). Les portes ET 801 à 807 présentent chacune une sortie qui est connectée à une entrée d'une porte ET 820 laquelle dispose d'une sortie connectée via un inverseur 840 à une première entrée d'une porte ET 830, dont deux autres entrées reçoivent les deux signaux d'enable des deux valeurs à comparer respectivement *enable_max_value* et *enable_trigger3*. En sortie, la porte ET 830 fournit un signal de sortie *Max_value_superior to Trigger3* qui est positif lorsque la valeur *Max_value* est supérieure ou égale à la valeur de consigne *Trigger3.*

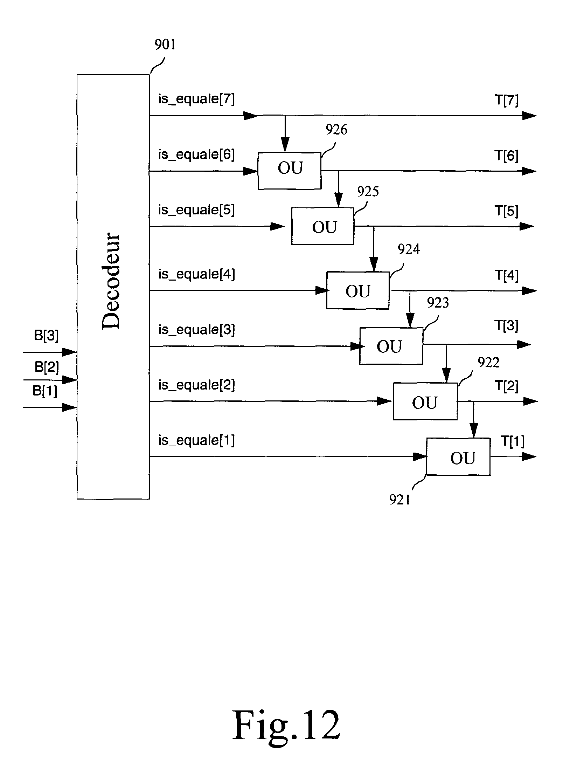

La figure 12 illustre une représentation sous forme de blocs fonctionnels d'une réalisation possible d'un circuit convertisseur en T, lequel convertit une valeur codée sur trois bits B[2] B[1] B[0] en sa transformée en T codée sur sept bits, respectivement T[7] à T[1]. Il est constitué d'un décodeur 901 et de six éléments logique de type OU, respectivement 921 à 926. Chacun des bits B[2], B[1], et B[0] est transmis décodeur 901, lequel fournit, en sortie, sept valeurs, respectivement dénommées is_equat[7], is_equal[6], is_equal[5], is_equal[4], is_equal[3], is_equal[2], is_equal[1]. La sortie is_equal[1] prend la valeur logique '1' lorsque B[2]='0' et B[1]= '0' et B[0]='1' et, dans le cas contraire, elle prend la valeur logique '0'. De la même manière, les sorties is_equa)[2] , is_equal[3], is_equal[4], is_equal [5], is_equal[6], is_equal[7], prennent la valeur logique '1' lorsque le triplet B[2]B[1] B[0], prend la valeur (0,1,0), (0,1,1), (1, 0, 0), (1,0,1), (1, 1, 0) et (1,1,1) respectivement, et la valeur nulle dans le cas contraire.

Six éléments logiques OU (resp 921 à 926) disposent chacun d'une première entrée connectée à l'une des sorties du décodeur 901 (resp. is_equale[1] à is_equale[6]) et d'une sortie fournissant un signal T(1) à T(6). Un signal T(7) provient directement de la sortie is_equale[7] du décodeur 901. Chacun des éléments OU (resp. 921 à 926) dispose en outre d'une seconde entrée qui est connectée à l'une des sorties, respectivement T(2) à T(7).

A partir de cette structure, une méthode d'optimisation manuelle ou l'utilisation d'un outil de synthèse logique permet de produire directement les structures électroniques sur silicium permettant de réalisation la fonction de conversion en T très rapide et une surface de silicium optimisée.

Il est clair que le circuit de la figure 12 n'est qu'un exemple parmi bien d'autres et que l'homme du métier pourra sans difficulté adapter l'invention à tout format de données signée ou non, sous forme mantisse et exposant ou autre, étant entendu qu'elle devront présenter la particularité de faire parti d'un ensemble sur lequel est défini une relation d'ordre.

Comme on le voit, le codage de l'information basé sur la fonction transformée en T définie précédemment permet la manipulation de données et ce d'une manière particulièrement rapide. L'homme du métier pourra, de manière directe, adapter l'emploi de cette fonction et de ses variantes à toute opération effectuée sur une collection de données. Clairement, la mise en oeuvre de la fonction transformée en T au sein d'un circuit semi-conducteur apporte des gains de vitesse considérables, dans un rapport de 5.

**Revendications**

1. Dispositif de traitement de données numériques appartenant à un ensemble de $2^n$ codes dans lequel une relation d'ordre est établie et pour lequel chacune desdites données dispose d'un rang R compris entre 0 et $2^n-1$, le circuit étant **caractérisé en ce qu'**il comporte :

   - un circuit de conversion pour chaque donnée numérique à traiter afin de générer une transformée qui est un nombre binaire composé de $2^n-1$ éléments binaires **T[x]** avec x = 1 à $2^n-1$ :
        **T[$2^n$-1] T[$2^n$-2] ...T[x]... T[2] T[1]**
     Dans lequel on a T(x) = 0 lorsque x est strictement supérieur à R et T(x)=1 lorsque x est inférieur ou égal à R,

   - des circuits recevant le résultat desdites conversion et effectuant un traitement numérique sur ledit résultat.

2. Dispositif de traitement de données numériques appartenant à un ensemble de $2^n$ codes dans lequel une relation d'ordre est établie et pour lequel chacune desdites données dispose d'un rang R compris entre 0 et $2^n-1$, le circuit étant **caractérisé en ce qu'**il comporte :

   - un circuit de conversion pour chaque donnée numérique à traiter afin de générer une transformée qui est un nombre binaire composé de $2^n$ éléments binaires **T[x]** avec x = 0 à $2^n-1$ :
        **T[$2^n$-1] T[$2^n$-2] ...T[x]... T[1] T[0]**
     Dans lequel on a T(x) = 0 lorsque x est strictement supérieur à R et T(x)=1 lorsque x est inférieur ou égal à R;

- des circuits recevant le résultat desdites conversion et effectuant un traitement numérique sur ledit résultat.

3. Dispositif selon l'une des revendications 1 ou 2 **caractérisé en ce que** ledit traitement numérique est un OU booléen, effectué bit a bit sur les bits de même indice des données transformées, suivi d'une conversion inverse de ladite transformée afin d'extraire le maximum d'un ensemble de valeurs numériques.

4. Dispositif selon la revendication 3 **caractérisé en ce que** l'extraction dudit maximum est suivie d'une comparaison par rapport à une autre valeur.

5. Dispositif selon l'une des revendications 1 ou 2 **caractérisé en ce que** ledit traitement numérique est un ET booléen, effectué bit a bit sur les bits de même indice des données transformées, suivi d'une conversion inverse de ladite transformée afin d'extraire le minimum d'un ensemble de valeurs numériques.

6. Dispositif selon la revendication 5 **caractérisé en ce que** l'extraction dudit minimum est suivie d'une comparaison par rapport à une autre valeur.

7. Dispositif de traitement de données numériques appartenant à un ensemble de $2^n$ codes dans lequel une relation d'ordre est établie et pour lequel chacune desdites données dispose d'un rang R compris entre 0 et $2^n$-1, le circuit étant **caractérisé en ce qu'**il comporte :

   - un circuit de conversion pour chaque donnée numérique à traiter afin de générer une transformée qui est un nombre binaire composé de $2^n$-1 éléments binaires **T[x]** avec x = 1 à $2^n$-1 :
     **T[$2^n$-1] T[$2^n$-2] ...T[x] ... T[2] T[1]**
     Dans lequel on a T(x) = 1 lorsque x est strictement supérieur à R et T(x)=0 lorsque x est inférieur ou égal à R;

   - des circuits recevant le résultat desdites conversion et effectuant un traitement numérique sur ledit résultat.

8. Dispositif de traitement de données numériques appartenant à un ensemble de $2^n$ codes dans lequel une relation d'ordre est établie et pour lequel chacune desdites données dispose d'un rang R compris entre 0 et $2^n$-1, le circuit étant **caractérisé en ce qu'**il comporte :
   un circuit de conversion pour chaque donnée numérique à traiter afin de générer une transformée qui est un nombre binaire composé de $2^n$ éléments binaires **T[x]** avec x = 0 à $2^n$-1:
     **T[$2^n$-1] T[$2^n$-2] ...T[x]... T[2] T[1] T[0]**
     Dans lequel on a T(x) = 1 lorsque x est strictement supérieur à R et T(x)=0 lorsque x est inférieur ou égal à R;

   - des circuits recevant le résultat desdites conversion et effectuant un traitement numérique sur ledit résultat.

9. Dispositif selon l'une des revendications 7 ou 8 **caractérisé en ce que** ledit traitement numérique est un ET booléen, effectué bit a bit sur les bits de même indice des données transformées, suivi d'une conversion inverse de ladite transformée afin d'extraire le maximum d'un ensemble de valeurs numériques.

10. Dispositif selon la revendication 9 **caractérisé en ce que** l'extraction dudit maximum est suivie d'une comparaison par rapport à une autre valeur.

11. Dispositif selon l'une des revendication 7 à 8 **caractérisé en ce que** ledit traitement numérique est un OU booléen, effectué bit a bit sur les bits de même indice des données transformées, suivi d'une conversion inverse de ladite transformée afin d'extraire le minimum d'un ensemble de valeurs numériques.

12. Dispositif selon la revendication 11 **caractérisé en ce que** l'extraction dudit minimum est suivie d'une comparaison par rapport à une autre valeur.

13. Dispositif selon l'une des revendications précédentes **caractérisée en ce que** ledit code originel des données numériques à traiter est du type signé, non signé, Gray, Johnson ou avec une mantisse et un exposant.

14. Dispositif selon l'une des revendications précédentes **caractérisées en ce que** l'on applique ladite transformée à un sous groupe d'éléments binaires de chaque données uniquement, afin de traiter en séquence différentes parties de chaque donnée.

**15.** Circuit d'extraction d'un maximum parmi un ensemble de données numériques appartenant à un ensemble de $2^n$ codes dans lequel une relation d'ordre est établie et pour lequel chacune desdites données dispose d'un rang R compris entre 0 et $2"-1$, le circuit étant **caractérisé en ce qu'**il comporte :

  - un circuit de représentation de chacune desdites données numériques à traiter basée sur un code composé de $2^n-1$ éléments binaires **T[x]** avec x = 1 à $2^n-1$:
      **T[$2^n$-1] T[$2^n$-2] ...T[x]... T[2] T[1]**
      Dans lequel on a T(x) = 0 lorsque x est strictement supérieur à R et T(x)=1 lorsque x est inférieur ou égal à R,

  - des circuits logiques réalisant un OU logique, effectué bit à bit sur les bits de même indice desdites données numériques, afin d'extraire le maximum dudit ensemble de valeurs numériques.

**16.** Circuit d'extraction d'un maximum parmi un ensemble de données numériques appartenant à un ensemble de $2^n$ codes dans lequel une relation d'ordre est établie et pour lequel chacune desdites données dispose d'un rang R compris entre 0 et $2^n-1$, le circuit étant **caractérisé en ce qu'**il comporte :

  - un circuit de représentation de chacune desdites données numériques à traiter basée sur un code composé de $2^n$ éléments binaires **T[x]** avec x = 0 à $2^n-1$ :
      **T[$2^n$-1] T[$2^n$-2] ...T[x]... T[1] T[0]**

      Dans lequel on a T(x) = 0 lorsque x est strictement supérieur à R et T(x)=1 lorsque x est inférieur ou égal à R, avec R étant le rang dans le dit ensemble ordonné ;
      des circuits logiques réalisant un OU logique, effectué bit à bit sur les bits de même indice desdites données numériques, afin d'extraire le maximum dudit ensemble de valeurs numériques.

**17.** Circuit d'extraction du minimum parmi un ensemble de données numériques appartenant à un ensemble de $2^n$ codes dans lequel une relation d'ordre est établie et pour lequel chacune desdites données dispose d'un rang R compris entre 0 et $2^n-1$, le circuit étant **caractérisé en ce qu'**il comporte :

  - un circuit de représentation de chacune desdites données numériques à traiter basée sur un code composé de $2^n-1$ éléments binaires **T[x]** avec x = 1 à $2^n-1$ :
      **T[$2^n$-1] T[$2^n$-2] ...T[x] ... T[2] T[1]**
      Dans lequel on a T(x) = 0 lorsque x est strictement supérieur à R et T(x)=1 lorsque x est inférieur ou égal à R,

  - des circuits logiques réalisant un ET logique, effectué bit à bit sur les bits de même indice desdites données numériques, afin d'extraire le minimum dudit ensemble de valeurs numériques.

**18.** Circuit d'extraction du minimum parmi un ensemble de données numériques appartenant à un ensemble de $2^n$ codes dans lequel une relation d'ordre est établie et pour lequel chacune desdites données dispose d'un rang R compris entre 0 et $2^n-1$, le circuit étant **caractérisé en ce qu'**il comporte :

  - un circuit de représentation de chacune desdites données numériques à traiter basée sur un code composé de $2^n$ éléments binaires **T[x]** avec x = 0 à $2^n-1$ :
      **T[$2^n$-1] T[$2^n$-2] ...T[x] ... T[1] T[0]**

      Dans lequel on a T(x) = 0 lorsque x est strictement supérieur à R et T(x)=1 lorsque x est inférieur ou égal à R, avec R étant le rang dans le dit ensemble ordonné ;
      des circuits logiques réalisant un ET logique, effectué bit à bit sur les bits de même indice desdites données numériques, afin d'extraire le minimum dudit ensemble de valeurs numériques.

**19.** Circuit d'extraction d'un maximum parmi un ensemble de données numériques appartenant à un ensemble de $2^n$ codes dans lequel une relation d'ordre est établie et pour lequel chacune desdites données dispose d'un rang R compris entre 0 et $2^n-1$, le circuit étant **caractérisé en ce qu'**il comporte :

  - un circuit de représentation de chacune desdites données numériques à traiter basée sur un code composé de $2^n-1$ éléments binaires **T[x]** avec x = 1 à $2^n-1$ :
      **T($2^n$-1) T($2^n$-2) ... T[x] ... T[2] T[1]**
      Dans lequel on a T(x) = 1 lorsque x est strictement supérieur à R et T(x)=0 lorsque x est inférieur ou égal à R,

- des circuits logiques réalisant un ET logique, effectué bit à bit sur les bits de même indice desdites données numériques, afin d'extraire le maximum dudit ensemble de valeurs numériques.

20. Circuit d'extraction d'un maximum parmi un ensemble de données numériques appartenant à un ensemble de $2^n$ codes dans lequel une relation d'ordre est établie et pour lequel chacune desdites données dispose d'un rang R compris entre 0 et $2^n-1$, le circuit étant **caractérisé en ce qu'**il comporte :

- un circuit de représentation de chacune desdites données numériques à traiter basée sur un code composé de $2^n$ éléments binaires **T[x]** avec x = 0 à $2^n-1$ :

    **T[$2^n$-1] T[$2^n$-2] ... T[x] ... T[1] T[0]**

Dans lequel on a T(x) = 1 lorsque x est strictement supérieur à R et T(x)=0 lorsque x est inférieur ou égal à R, avec R étant le rang dans le dit ensemble ordonné ;
des circuits logiques réalisant un ET logique, effectué bit à bit sur les bits de même indice desdites données numériques, afin d'extraire le maximum dudit ensemble de valeurs numériques.

21. Circuit d'extraction du minimum parmi un ensemble de données numériques appartenant à un ensemble de $2^n$ codes dans lequel une relation d'ordre est établie et pour lequel chacune desdites données dispose d'un rang R compris entre 0 et $2^n-1$, le circuit étant **caractérisé en ce qu'**il comporte :

- un circuit de représentation de chacune desdites données numériques à traiter basée sur un code composé de $2^n$-1 éléments binaires **T[x]** avec x = 1 à $2^n-1$ :
    **T[$2^n$-1] T[$2^n$-2] ...T[x] ... T[2] T[1]**
Dans lequel on a T(x) = 1 lorsque x est strictement supérieur à R et T(x)=0 lorsque x est inférieur ou égal à R,

- des circuits logiques réalisant un OU logique, effectué bit à bit sur les bits de même indice desdites données numériques, afin d'extraire le minimum dudit ensemble de valeurs numériques.

22. Circuit d'extraction du minimum parmi un ensemble de données numériques appartenant à un ensemble de $2^n$ codes dans lequel une relation d'ordre est établie et pour lequel chacune desdites données dispose d'un rang R compris entre 0 et $2^n-1$, le circuit étant **caractérisé en ce qu'**il comporte :

- un circuit de représentation de chacune desdites données numériques à traiter basée sur un code composé de $2^n$ éléments binaires **T[x]** avec x = 0 à $2^n-1$ :
    **T[$2^n$-1] T[$2^n$-2] ... T[x] ... T[1] T[0]**

Dans lequel on a T(x) = 1 lorsque x est strictement supérieur à R et T(x)=0 lorsque x est inférieur ou égal à R, avec R étant le rang dans le dit ensemble ordonné ;
des circuits logiques réalisant un OU logique, effectué bit à bit sur les bits de même indice desdites données numériques, afin d'extraire le minimum dudit ensemble de valeurs numériques.

23. Circuit selon l'une quelconque des revendications 15 à 22 **caractérisé en ce que** l'on applique ladite transformée à un sous groupe d'éléments binaires de chaque données uniquement, afin de traiter en séquence différentes parties de chaque donnée.

Fig. 1

Fig. 2

# Fig. 3

# Fig. 4

Fig. 5

Fig. 6

Fig. 7

Fig. 8

DATA_X[7]
Max_value[7]

607
OUexc

617
Inv

620

DATA_X[6]
Max_value[6]

606
OUexc

616
Inv

DATA_X[5]
Max_value[5]

605
OUexc

615
Inv

is_equal

DATA_X[4]
Max_value[4]

604
OUexc

614
Inv

DATA_X[3]
Max_value[3]

603
OUexc

613
Inv

ET

DATA_X[2]
Max_value[2]

602
OUexc

612
Inv

DATA_X[1]
Max_value[1]

601
OUexc

611
Inv

enable_max_value

Fig. 9

Fig. 10

Fig.11

901

is_equale[7]                                          T[7]

is_equale[6]                    926                    T[6]
                          OU

is_equale[5]                    925                    T[5]
                                OU

is_equale[4]                    924                    T[4]
                                    OU

is_equale[3]                    923                    T[3]
                                        OU

is_equale[2]                    922                    T[2]
                                            OU

is_equale[1]                                          T[1]
                                                OU

Decodeur

B[3]

B[2]

B[1]

921

# Fig.12

## RAPPORT DE RECHERCHE EUROPEENNE

**Office européen des brevets**

Numéro de la demande

EP 03 36 8126

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | HOFFMAN R.: "Data compression in digital systems; Section 4.3. : Run Length coding" 1997, CHAPMAN AND HALL , US, NEW YORK , XP002257620 | 1,2,7,8, 15-22 | H03M5/00 H03M5/04 H03M7/40 H03M5/14 |
| Y | * page 56 - page 57 * | 3-6,9-14 | G11B20/14 H03M7/46 |
| Y | US 5 586 288 A (DAHLBERG BJORN) 17 décembre 1996 (1996-12-17) * colonne 5, ligne 27 - colonne 7, ligne 26 * * figure 3 * | 3-6,9-14 | G06F7/00 G06F7/02 G06F17/30 G06F7/544 H03H17/02 |
| X | MARSAULT X: "CHAPITRE 2;GENERALITES ET PREMIERS EXEMPLES" COMPRESSION ET CRYPTAGE DES DONNEES MULTIMEDIAS, PARIS, EDITIONS HERMES, FR, 1995, pages 23-68,231-236, XP000955515 ISBN: 2-86601-482-0 * le document en entier * | 1-22 | |
| X | HELD G: "Data Compression;Techniques and Applications;Hardware and Software Considerations" DATA COMPRESSION. TECHNIQUES AND APPLICATIONS HARDWARE AND SOFTWARE CONSIDERATIONS, CHICHESTER, J.WILEY & SONS, GB, 1983, pages 18-20,26-40, XP002252154 * le document en entier * | 1-22 | **DOMAINES TECHNIQUES RECHERCHES (Int.Cl.7)** H03M G11B G06F H03H |
| A | US 5 262 969 A (ISHIHARA SHINGO) 16 novembre 1993 (1993-11-16) * colonne 5, ligne 22 - ligne 36 * * figure 5 * | 3-6,9-14 | |

-/--

Le présent rapport a été établi pour toutes les revendications

| Lieu de la recherche | Date d'achèvement de la recherche | Examinateur |
|---|---|---|
| La Haye | 10 mai 2004 | Barel-Faucheux, C |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**Office européen des brevets**

**RAPPORT DE RECHERCHE EUROPEENNE**

Numéro de la demande

EP 03 36 8126

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | US 5 532 948 A (KATO MASAHIRO ET AL) 2 juillet 1996 (1996-07-02) * colonne 4, ligne 18 - colonne 8, ligne 13 * * colonne 8, ligne 23 - ligne 57 * * figures 2,3 * | 3-6,9-14 | |
| A | US 5 721 809 A (PARK SOUNG HWI) 24 février 1998 (1998-02-24) * le document en entier * | 3-6,9-14 | |
| A | US 5 122 979 A (CULVERHOUSE PHILIP F) 16 juin 1992 (1992-06-16) * le document en entier * | 3-6,9-14 | |

DOMAINES TECHNIQUES RECHERCHES (Int.Cl.7)

Le présent rapport a été établi pour toutes les revendications

| Lieu de la recherche | Date d'achèvement de la recherche | Examinateur |
|---|---|---|
| La Haye | 10 mai 2004 | Barel-Faucheux, C |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE**
**RELATIF A LA DEMANDE DE BREVET EUROPEEN NO.**          EP 03 36 8126

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

10-05-2004

| Document brevet cité au rapport de recherche | | Date de publication | Membre(s) de la famille de brevet(s) | | Date de publication |
|---|---|---|---|---|---|
| US 5586288 | A | 17-12-1996 | AUCUN | | |
| US 5262969 | A | 16-11-1993 | JP | 2637862 B2 | 06-08-1997 |
| | | | JP | 4352031 A | 07-12-1992 |
| | | | CA | 2070035 A1 | 30-11-1992 |
| US 5532948 | A | 02-07-1996 | JP | 2812126 B2 | 22-10-1998 |
| | | | JP | 6215129 A | 05-08-1994 |
| | | | CA | 2113140 A1 | 14-07-1994 |
| | | | GB | 2274366 A ,B | 20-07-1994 |
| | | | KR | 156594 B1 | 16-11-1998 |
| | | | US | 5737251 A | 07-04-1998 |
| US 5721809 | A | 24-02-1998 | KR | 156152 B1 | 16-11-1998 |
| | | | JP | 3198379 B2 | 13-08-2001 |
| | | | JP | 8339291 A | 24-12-1996 |
| US 5122979 | A | 16-06-1992 | GB | 2232280 A | 05-12-1990 |

EPO FORM P0460

Pour tout renseignement concernant cette annexe : voir Journal Officiel de l'Office européen des brevets, No.12/82